# EUROPÄISCHE PATENTSCHRIFT

(11) **EP 0 644 669 B1**
(45) Veröffentlichungstag und Bekanntmachung des Hinweises auf die Patenterteilung: **08.08.2001**
(21) Anmeldenummer: 93114860.5
(22) Anmeldetag: 15.09.1993
(51) Int. Cl.: H04B 10/24

(54) **Sende- und Empfangsmodul mit temperaturstabilisierter Sendewellenlänge**
Transmitting and receiving module with temperature stabilised transmitting wavelength
Module émetteur-récepteur avec longveur d'onde d'émissions stabilisée en température

(43) Veröffentlichungstag der Anmeldung: 22.03.1995
(73) Patentinhaber: Infineon Technologies AG, 81669 München (DE)
(72) Erfinder: Althaus, Hans Ludwig, Dr.rer.nat., D-93138 Lappersdorf (DE); Kuhn, Gerhard, Dr.rer.nat., D-93087 Alteglofsheim (DE); Panzer, Klaus, Dr.-Ing., D-93049 Regensburg (DE)
(74) Vertreter: Zedlitz, Peter, Dipl.-Inf.

(56) Entgegenhaltungen:
- EP-A- 0 463 214
- FERNSEH UND KINO TECHNIK Bd. 46, Nr. 6 , Juni 1992 , BERLIN DE Seiten 402 - 404 J.YAMASHITA ET AL 'Optoelektronische Module für die faseroptische Nachrichtentechnik'
- ELECTRONICS AND COMMUNICATION ENGINEERING JOURNAL Bd. 2, Nr. 2 , April 1990 , LONDON GB Seiten 79 - 84 A.R.HUNWICKS ET AL 'Use of optical "feedthrough" transceivers for bidirectional transmission systems'

## Beschreibung

Die Erfindung bezieht sich auf einen Sende- und Empfangsmodul für eine bidirektionale optische Nachrichten- und Signalübertragung nacn dem Oberbegriff des Anspruchs 1.

Ein Sende- und Empfangsmodul (Transceiver) für eine bidirektionale optische Nachrichten- und Signalübertragung geht aus der EP-A-0463 214 als bekannt hervor. Bei diesem Modul sind die beiden aktiven Bauelemente (Lichtsender und Lichtempfänger) als eigenständige Bauelemente hermetisch dicht abgekapselt in ein gemeinsames Modulgenäuse eingebaut, in dessen Hohlrauminneren ein Strahlteiler und eine Linsenkoppeloptik angeordnet sind und das einen Faseranschluß für eine gemeinsame Lichtleitfaser aufweist.

Derartige Sende- und Empfangsmodule sind Schlüsselbauelemente für die optische Übertragung im Teilnehmerbereich von Telekommunikationssystemen, beispielsweise in Breitband-ISDN-Netzen. Besonders vorteilhaft bei der Anwendung optiscner Übertragungstechnik im Teilnehmeranschluß ist die bidirektionale Übertragung auf nur einer Lichtleitfaser. Für die Trennung der entgegengesetzt laufenden Nachrichtensignale an den Enden der Lichtfaserstrecke eignet sich ein derartiger Modul besonders, zumal er die bisher erforderliche diskrete Lösung aus Sender, Empfänger und Spiegel zur Strahltrennung ersetzt. Der Spiegel bzw. Strahlteiler erlaubt sowohl die Übertragung mit verschiedenen Wellenlängen, für die er als wellenlängenselektives Filter (Wellenlängenmultiplex) ausgeführt ist, als auch bei gleicher Wellenlänge, für die er teildurchlässig (beam splitting) ist. In beiden Fällen läßt der Teiler das Sendesignal durcn und koppelt das Empfangssignal über Reflexion aus.

Da bei Telekommunikationssystemen für die interaktiven Dienste in zwei Richtungen übertragen werden muß, benutzt man hierfür zwei verschiedene optische Wellenlängen. Um diese Wellenlängen in einfacher Weise trennen zu können, sollten sie möglichst weit auseinander liegen, zweckmäßig z.B. bei 1300nm und 1550nm. Zusätzliche Dienste, wie Verteilfernsehen, müssen auf anderen Wellenlängen untergebracnt werden. Für die Verteildienste wird bisher ein zusätzliches Glasfasernetz verwendet, in dem man bezüglich der Wahl der Wellenlänge frei ist.

Bei kleinem Abstand der Wellenlängen für die interaktiven Dienste sind die Anforderungen an das optische Filter, d.h. an den Spiegel bzw. Strahlteiler hoch, und es werden optische Sender mit sehr stabilen Emissionswellenlängen benötigt.

Der Erfindung liegt die Aufgabe zugrunde, einen optischen Sende- und Empfangsmodul der eingangs genannten Gattung so auszubilden, daß dessen optischer Sender eine Strahlung mit sehr stabiler Emissionswellenlänge erzeugt.

Diese Aufgabe wird erfindungsgemäß durch einen Sende- und Empfangsmodul mit den Merkmalen des Anspruchs 1 gelöst.

Vorteilhafte Ausgestaltungen bzw. Weiterbildungen der Erfindung sind Gegenstand zusätzlicher Ansprüche.

Die mit der Erfindung erzielten Vorteile bestenen insbesondere darin, daß mit dem erfindungsgemäßen Transceiver-Modul alle Telekommunikationsdienste, d.h. interaktive Dienste und Verteildienste auf einer Lichtleitfaser zum Teilnehmer gebracht werden können. Das wird dadurch ermöglicht, daß für die interaktiven Dienste vorzugsweise ein dichtes WDM (Wavelength Division Multiplexing) im Bereich von 1300nm vorgenommen wird, während die Verteildienste dann zweckmäßig auf einer optischen Wellenlänge von 1550nm übertragen werden können. Die integrierte Modulbauweise der hierzu verwendeten Bauteile verkleinert den Platzbedarf, verkürzt die Montagezeit und reduziert den Bauteileaufwand. Durch den Einsatz von Laser- und Fotodioden als Serienkomponenten wird eine kostengünstige Fertigung ermöglicht. Beide Diodenarten können vorzugsweise in der TO-Standardbauform ausgeführt sein und bilden zusammen mit den im freien Strahlengang angeordneten Strahlteilern die Grundelemente des Transceiver-Moduls.

Dadurch, daß bei dem Modul für bidirektionale Übertragung für die als optischer Sender dienende Laserdiode eine Heizeinrichtung vorgesehen ist, wird ohne großen Aufwand eine hohe Stabilisierung der Emissionswellenlänge erreicht, so daß sich eine kompakte Empfangsanordnung insbesondere für alle Dienste auf der Teilnehmerseite eines Telekommunikationssystems ergibt. Die aufwandsarme Heizeinrichtung für eine Laserdiode als optischen Sender ist sowohl für Zweikanal-Transceiver-Module, als auch für Mehrkanal-Transceiver-Module zur thermischen Emissionswellenlängenstabilisierung besonders geeignet.

Anhand von in den Figuren der Zeichnung dargestellten Ausführungsbeispielen wird die Erfindung im folgenden näher erläutert. Es zeigen
- FIG 1: einen Transceiver-Modul mit externer Heizeinrichtung,
- FIG 2: einen Transceiver-Modul mit externer Heizeinrichtung,
- FIG 3: eine Laserdiode des Transceiver-Moduls mit interner Heizeinrichtung,
- FIG 4: eine Laserdiode mit interner Heizeinrichtung,
- FIG 5: die Heizeinrichtung der FIG 4 im Ausschnitt,
- FIG 6: eine Laserdiode mit interner Heizeinrichtung,
- FIG 7: die Heizeinrichtung der FIG 6 im Ausschnitt,
- FIG 8: eine Laserdiode mit einer weiteren internen Heizeinrichtung,
- FIG 9: die Heizeinrichtung der FIG 8 im Ausschnitt und
- FIG 10: eine Regelschaltung.

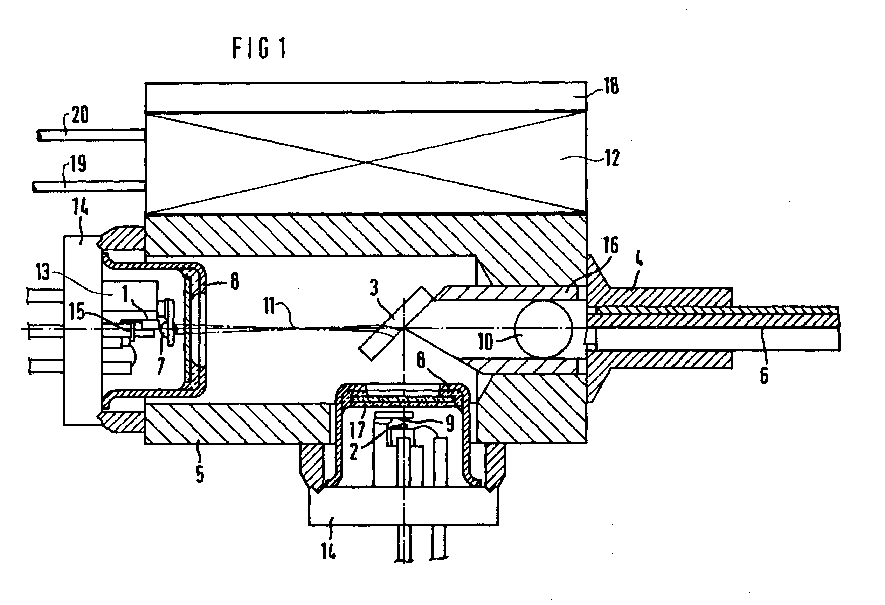

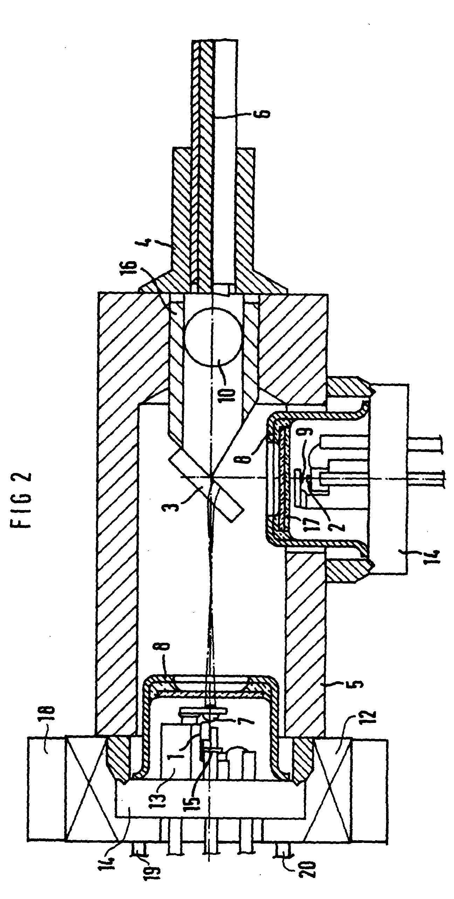

Der in den Figuren 1 und 2 vollkommen und in den übrigen Figuren teilweise dargestellte Sende- und Empfangsmodul bzw. Transceiver-Modul für eine bidirektionale optische Nachrichten- und Signalübertragung besteht in diesen Beispielen als Zweikanal-Modul im wesentlichen aus einem optiscnen Sender 1, einem optischen Empfänger 2, einem Faseranschluß 4 für eine gemeinsame Lichtleitfaser 6, einer Linsenkoppeloptik 7, 9, 10 und einem im freien Strahlengang 11 zwischengeordneten Strahlteiler 3, die in einem gemeinsamen Gehäuse 5 angeordnet sind, das zweckmäßig aus Metall besteht.

Der optische Sender bzw. die Laserdiode 1 und der optische Empfänger, zweckmäßig eine Fotodiode 2, sind jeweils ein eigenständiges Bauelement bildend von einer Einkapselung 8 umgeben. Als Einkapselungen 8 ist ein sogenanntes TO-Gehäuse besonders geeignet. Die eigenständigen Bauelemente 1, 2 sind in ihren TO-Gehäusen bzw. Einkapselungen 8 mit dem Strahlteiler 3 und der Linsenkoppeloptik, beispielsweise den Kugellinsen 7, 9, 10 in das gemeinsame Gehäuse 5 eingebaut.

Der optische Sender umfaßt ein auf einer Grundplatte 14 befestigtes Trägerteil 13 für die Laserdiode 1 mit rückseitiger Monitordiode 15 sowie eine Linse 7, zweckmäßig Kugellinse als Koppeloptik. Die umweltempfindliche Monitor-Laser-Linsen-Anordnung ist hermetisch dicht mit der Einkapselung 8 in diesem Beispiel in Form einer Planfensterkappe verschlossen. Der optische Empfänger 2 bzw. die Detektoranordnung ist wiederum auf einer Grundplatte 14 befestigt und in ein TO-Gehäuse als Einkapselung 8 eingebaut. Die hermetisch dichte Einkapselung 8 ist in diesem Beispiel wiederum eine Planfensterkappe. Sofern zum Unterdrücken eines störenden Übersprechens dem optischen Empfänger 2, beispielsweise einer Fotodiode, ein Sperrfilter 17 vorgescnaltet werden soll, kann dieses innerhalb oder außernalb der Kappe 8 am Planfenster fixiert sein. Das Planfenster der Kappe 8 kann auch selbst als Sperrfilter zum Unterdrücken einer bestimmten optischen Wellenlänge ausgebildet sein. Als Linsenkoppeloptik ist in diesem Beispiel eine innerhalb der Detektoranordnung angebrachte Kugellinse 9 vorgesehen.

Der Strahlteiler 3 bildet eine optische Trenneinrichtung für verschiedene oder gleiche optische Wellenlängen. Für verschiedene optische Wellenlängen von Sende- und Empfangszweig, d.h. wenn der Strahlteiler wellenlängenselektiv arbeitet, kann eine Trennung von größer als 95% erreicht werden. Bei gleicher Wellenlänge kann für beide Zweige z.B. eine 50%ige oder andere Trennung eingestellt werden.

Zur Ein- oder Auskopplung der optischen Strahlung aus der gemeinsamen Lichtleitfaser 6 ist als Koppeloptik eine Linse 10, beispielsweise eine Kugellinse vorgesehen, die in einer Halterung 16 befestigt ist.

Die gemeinsame Lichtleitfaser kann sowohl fest als auch lösbar (Steckerbuchse) am Modulgehäuse 5 fixiert sein. Die Fixierung der Baugruppen (Sender- und Empfängereinheit) kann z.B. durch Laserschweißen an das gemeinsame Gehäuse 5 (Modulgehäuse) erfolgen.

Bei den in den FIG 1 und 2 dargestellten Ausführungsbeispielen ist die Heizeinrichtung 12 für die Laserdiode 1 bzw. den Laserdiodenchip außen am gemeinsamen Gehäuse 5 angebracht. Als Heizeinrichtung 12 wird zweckmäßig eine Widerstandsheizung oder ein Peltier-Kühler verwendet. Eine solche Heizeinrichtung ist relativ einfach realisierbar, da sie an Serienmodulen nach Bedarf anwendbar ist. Eine thermische Abschirmung 18 des Gehäuses 5 gegen die Umgebung kann die notwendige Heizleistung reduzieren. Die beiden Heizanschlüsse sind mit den Bezugszeichen 19, 20 versehen.

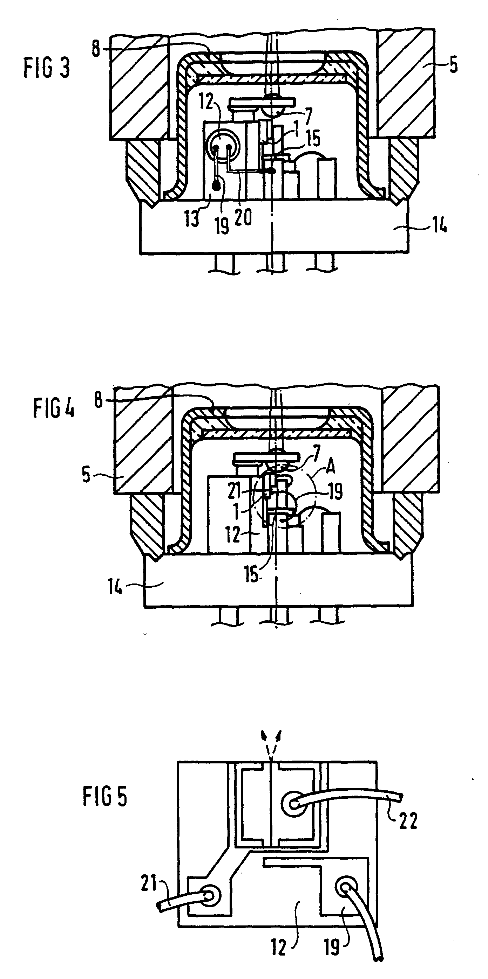

Bei dem in FIG 3 dargestellten Ausführungsbeispiel sowie bei den weiteren Beispielen befindet sich die Heizeinrichtung 12 für die Laserdiode 1 im Inneren der Einkapselung 8 bzw. im Inneren des bevorzugt verwendeten TO-Gehäuses. Gemäß FIG 3 ist die Heizeinrichtung 12 in Gestalt einer Heizwendel oder Heizpatrone in das gemeinsame Trägerteil 13 eingesetzt, das die Wärmesenke für die Laserdiode 1 bildet. Die beiden Heizanschlüsse sind mit den Bezugszeichen 19, 20 versehen.

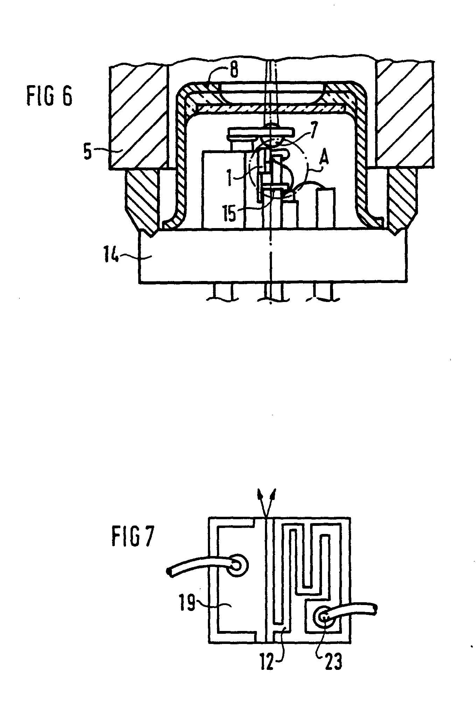

Bei dem in den FIG 4 und 5 dargestellten optischen Sender ist der Laserdiodenträger als Heizeinrichtung 12 ausgebildet. Zu diesem Zweck kann auf dem Laserdioden-Submount eine Heizwendel galvanisch oder photochemisch aufgebracht werden. Der Heizanschluß 19 kann an Masse oder an einem der isolierten Pins herausgeführt werden. Die Kathode der Laserdiode 1 ist in FIG 5 in der vergrößerten Seitenansicht (Ausschnitt aus FIG 4) mit dem Bezugszeichen 21 und die Anode mit dem Bezugszeichen 22 versehen.

Bei dem in den FIG 6 und 7 dargestellten optischen Senderbauteil ist die Heizeinrichtung 12 direkt am Laserchip 1 in der Nähe dessen aktiver Zone vorgesehen. Auf den Lasercnip 1 kann die Heizeinrichtung 12 in Gestalt einer mäanderförmigen Metallisierung aufgebracht sein, die an einem Ende mit dem p-Kontakt der Laserdiode 1 verbunden ist. Zum Anschluß des anderen Endes erhält der Chip 1 einen zusätzlichen Kontakt 23 für die Zuführung des Heizstromes.

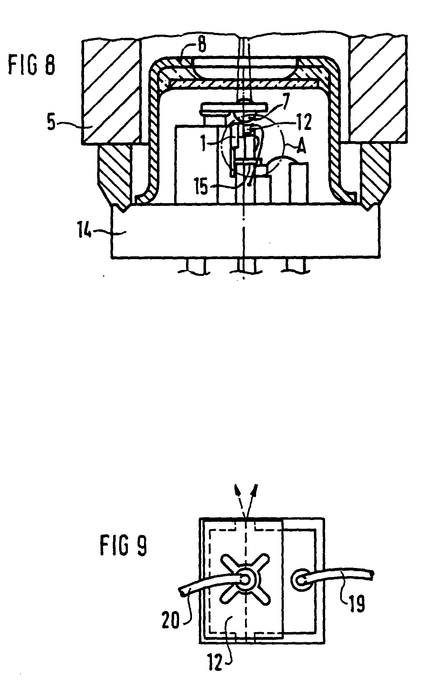

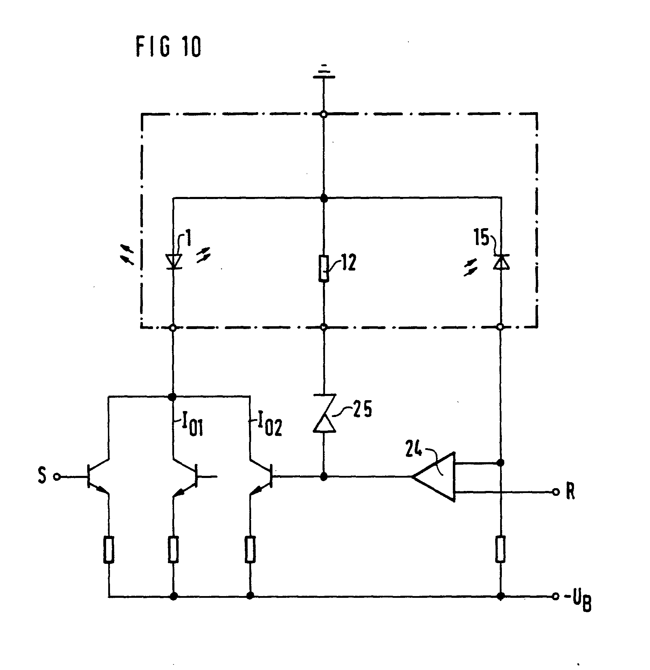

Bei dem Ausführungsbeispiel gemäß den FIG 8 und 9 ist der Laserchip 1 mit einem zusätzlichen Heizchip als Heizeinrichtung 12 verbunden, der beispielsweise auf den p-Kontakt so aufgesetzt wird, daß der p-Anschluß des Laserchips 1 auch für die Kontaktierung des Heizchips 12 benutzt wird. Es kann z.B. neben einem ohmschen Heizleiterchip auch ein Halbleiterchip, wie z.B. eine lichtemittierende Diode (LED, IRED) verwendet werden. SiC hat dabei wegen der relativ hohen Flußspannung bei einer 5V Stromversorgung Vorteile im Wirkungsgrad der Heizung gegenüber z.B. GaAlAs.

Die Heizeinrichtung direkt am Laserchip in der Nähe der aktiven Zone vorzusehen, ist die effektivste Lösung, da wegen des relativ großen Wärmewiderstandes hier eine kleine Heizleistung (z.B. 0,5W für 60K Erwärmung) ausreicht.

Die Regelung der Heizung kann beispielsweise über einen Thermistor erfolgen. Bei der besonders vorteilhaften Verwendung von TO-Gehäusen für die Sende- und Empfangsbauteile ist bei interner Heizeinrichtung der Einbau eines Thermistors allerdings schwierig, da in diesem Gehäuse neben dem Masseanschluß nur drei isolierte Anschlüsse zur Verfügung stehen, die im Falle des optischen Senders mit Laserdiode, Monitordiode und Heizeinrichtung bereits belegt sind, so daß für einen Thermistor keine Anschlüsse zur Verfügung stehen.

Gemäß einer vorteilhaften Ausgestaltung der Erfindung ist daher vorgesehen, die Heizung 12 der Laserdiode 1 über die Lichtleistung zu regeln, wie die Schaltungsanordnung gemäß FIG 10 vom Prinzip her zeigt. Der Laserdiode wird dabei neben dem Signalstrom S noch ein konstanter Gleichstrom I01 zugeführt. Daneben erhält die Laserdiode 1 noch einen zusätzlichen Gleichstrom I02, der in der üblichen Weise mit Hilfe der Monitorphotodiode 15 und des mit einem Referenzsignal R gesteuerten Regelverstärkers 24 für eine konstante Lichtleistung sorgt. Wenn die Temperatur sinkt, erreicht die Regelung einmal den Punkt, wo I02 gegen Null geht. An diesem Punkt muß dann die Heizung einsetzen, indem z.B. die Zenerdiode 25 im Heizkreis leitend wird. Die Regelung steuert dann den Heizstrom so, daß mit dem konstanten Strom IO1 die Lichtleistung konstant bleibt. Dadurch bleibt auch die Lasertemperatur und die Emissionswellenlänge konstant.

## Patentansprüche

1. Sende- und Empfangsmodul für eine bidirektionale optische Nachrichten- und Signalübertragung mit mindestens einem optischen Sender (1), mindestens einem optischen Empfänger (2), mindestens einem Faseranschluß (4) für eine Lichtleitfaser (6), einer Linsenkoppeloptik (7, 9, 10) und wenigstens einem im freien Strahlengang (11) zwischengeordneten Strahlteiler (3), die in einem gemeinsamen Gehäuse (5) angeordnet sind,
**dadurch gekennzeichnet,** daß der optische Sender (1) eine Laserdiode ist, die mit einer Heizeinrichtung (12) direkt oder indirekt verbunden ist.

2. Modul nach Anspruch 1, **dadurch gekennzeichnet,** daß der optische Sender (1) und der optische Empfänger (2) jeweils ein eigenständiges Bauelement bildend von einer Einkapselung (8) umgeben sind, und daß die eigenständigen Bauelemente mit ihren Einkapselungen (8) in das gemeinsame Gehäuse (5) mit dem Strahlteiler (3) und der Linsenkoppeloptik (7, 9, 10) eingebaut sind.

3. Modul nach Anspruch 1 oder 2, **dadurch gekennzeichnet,** daß der Strahlteiler (3) eine bestimmte Wellenlänge in einem vorgegebenen Verhältnis aufteilt.

4. Modul nach Anspruch 1 oder 2, **dadurch gekennzeichnet**, daß der Strahlteiler (3) ein wellenlängenselektiver Strahlteiler ist.

5. Modul nach einem der Ansprüche 1 bis 4, **dadurch gekennzeichnet,** daß die Heizeinrichtung (12) im Bereich des optischen Senders (1) außen am gemeinsamen Gehäuse (5) angebracht ist.

6. Modul nach einem der Ansprüche 1 bis 4, **dadurch gekennzeichnet,** daß die Heizeinrichtung (12) im Inneren der Einkapselung (8) der Laserdiode (1) vorgesehen ist.

7. Modul nach Anspruch 6, **dadurch gekennzeichnet,** daß die Heizeinrichtung (12) in der Wärmesenke (13) der Laserdiode (1) vorgesehen ist.

8. Modul nach Anspruch 6, **dadurch gekennzeichnet,** daß der Träger der Laserdiode (1) als Heizeinrichtung (12) ausgebildet ist.

9. Modul nach einem der Ansprüche 1 bis 4, **dadurch gekennzeichnet,** daß die Heizeinrichtung (12) direkt am Laserdiodenchip (1) in der Nähe dessen aktiver Zone angebracht ist.

10. Modul nach Anspruch 9, **dadurch gekennzeichnet,** daß am Laserdiodenchip (1) als Heizeinrichtung (12) eine Heizwendel angebracht ist.

11. Modul nach Anspruch 9, **dadurch gekennzeichnet,** daß am Laserdiodenchip (1) als Heizeinrichtung (12) ein Halbleiterchip angebracht ist.

12. Modul nach Anspruch 11, **dadurch gekennzeichnet,** daß der Halbleiterchip aus SiC besteht.

## Claims

1. Transceiver module for a bidirectional optical message and signal transmission comprising at least one optical transmitter (1), at least on optical receiver (2), at least one fibre connection (4) for an optical fibre (6), lens coupling optics (7, 9, 10) and at least one beam divider (3) which is interposed in the free beam path (11), which are arranged in a common case (5), characterized in that the optical transmitter (1) is a laser diode which is directly or indirectly connected to a heating device (12).

2. Module according to Claim 1, characterized in that the optical transmitter (1) and the optical receiver (2), forming in each case an independent component, are surrounded by an encapsulation (8) and in that the independent components with their encapsulations (8) are built into the common case (5) with the beam divider (3) and the lens coupling optics (7, 9, 10).

3. Module according to Claim 1 or 2, characterized in that the beam divider (3) divides a certain wavelength in a predetermined ratio.

4. Module according to Claim 1 or 2, characterized in that the beam divider (3) is a wavelength-selective beam divider.

5. Module according to one of Claims 1 to 4, characterized in that the heating device (12) is attached to the outside of the common case (5) in the area of the optical transmitter (1).

6. Module according to one of Claims 1 to 4, characterized in that the heating device (12) is provided in the interior of the encapsulation (8) of the laser diode (1).

7. Module according to Claim 6, characterized in that the heating device (12) is provided in the heat sink (13) of the laser diode (1).

8. Module according to Claim 6, characterized in that the support of the laser diode (1) is constructed as heating device (12).

9. Module according to one of Claims 1 to 4, characterized in that the heating device (12) is attached directly to the laser diode chip (1) in the vicinity of its active zone.

10. Module according to Claim 9, characterized in that a heating spiral is attached as heating device (12) to the laser diode chip (1).

11. Module according to Claim 9, characterized in that a semiconductor chip is attached as heating device (12) to the laser diode chip (1).

12. Module according to Claim 11, characterized in that the semiconductor chip consists of SiC.

## Revendications

1. Module émetteur et récepteur pour une transmission optique bidirectionnelle d'informations et de signaux, comportant au moins un émetteur (1) optique, au moins un récepteur (2) optique, au moins un raccordement (4) de fibre pour une fibre (6) optique, une optique (7, 9, 10) de couplage à lentille et au moins un séparateur (3) de faisceaux interposé dans la marche (11) libre du faisceau, qui sont montés dans un boîtier (5) commun, caractérisé en ce que l'émetteur (1) optique est une diode laser qui est reliée directement ou indirectement à un dispositif (12) de chauffage.

2. Module suivant la revendication 1, caractérisé en ce que l'émetteur (1) optique et le récepteur (2) optique sont entourés, chacun en formant un composant autonome, d'un encapsulage (8) et en ce que les composants autonomes avec leur encapsulage (8) sont montés dans le boîtier (5) commun, conjointement avec le séparateur (3) de faisceaux et l'optique (7, 9, 10) de couplage à lentille.

3. Module suivant la revendication 1 ou 2, caractérisé en ce que le séparateur (3) de faisceaux sépare une longueur d'onde déterminée dans un rapport prescrit.

4. Module suivant la revendication 1 ou 2, caractérisé en ce que le séparateur (3) de faisceaux est un séparateur de faisceaux sélectif vis-à-vis des longueurs d'onde.

5. Module suivant l'une des revendications 1 à 4, caractérisé en ce que le dispositif (12) de chauffage est monté dans la zone de l'émetteur (1) optique, à l'extérieur sur le boîtier (5) commun.

6. Module suivant l'une des revendications 1 à 4, caractérisé en ce que le dispositif (12) de chauffage est prévu à l'intérieur de l'encapsulage (8) de la diode (1) laser.

7. Module suivant la revendication 6, caractérisé en ce que le dispositif (12) de chauffage est prévu dans le puits (13) de chaleur de la diode (1) laser.

8. Module suivant la revendication 6, caractérisé en ce que le support de la diode (1) laser est réalisé en dispositif (12) de chauffage.

9. Module suivant l'une des revendications 1 à 4, caractérisé en ce que le dispositif (12) de chauffage est monté directement sur la puce (1) de diode laser à proximité de sa zone active.

10. Module suivant la revendication 9, caractérisé en ce qu'il est monté sur la puce (1) de diode laser comme dispositif (12) de chauffage, un filament chauffant.

11. Module suivant la revendication 9, caractérisé en ce qu'il est monté sur la puce (1) de diode laser, comme dispositif (12) de chauffage, une puce à semi-conducteur.

12. Module suivant la revendication 11, caractérisé en ce que la puce à semi-conducteur est en SiC.
